# EUROPEAN PATENT SPECIFICATION

(11) **EP 2 048 753 B1**
(45) Date of publication and mention of the grant of the patent: **25.11.2009**
(21) Application number: 07291239.7
(22) Date of filing: 11.10.2007
(51) Int. Cl.: H01S 5/12, H01S 5/227, H01S 5/06

(54) **Laser module and method of providing a laser module**
Lasermodul und Verfahren zur Herstellung eines Lasermoduls
Module laser et procédé pour la fourniture de module laser

(43) Date of publication of application: 15.04.2009
(73) Proprietor: Alcatel Lucent, 75008 Paris (FR)
(72) Inventor: Pfeiffer, Thomas, 70569 Stuttgart (DE); Templ, Wolfgang, 74372 Sersheim (DE)
(74) Representative: Schmidt, Werner Karl

(56) References cited:
- JP-A- 1 212 487
- JP-A- 9 270 568
- US-A- 4 532 632
- US-A- 5 772 905
- US-A1- 2007 183 470
- US-B1- 6 363 097
- US-B1- 6 738 404

## Description

The invention relates to a laser module according to the preamble of claim 1 comprising a semiconductor laser having a bulk region and an active region arranged in said bulk region.

The invention further relates to a method of providing a laser module of the aforementioned type.

Prior art laser modules either have a fixed wavelength which may pose an inventory problem on manufacturers and suppliers that are required by their customers to offer a wide variety of such laser modules covering the possible wavelength ranges.

Further known systems comprise tunable lasers, i.e. laser systems a wavelength of which may flexibly be changed during operation. These systems require a complex hardware and are prone to damage when used in target systems other than laboratory environments, e.g. in the field.

US 4,532,632 discloses a tunable semiconductor laser which has an active layer, an insulating film made of a piezoelectric material and formed on a portion of the active layer, and an interdigital transducer provided on the insulating film for generating a surface acoustic wave (SAW). The laser oscillation wavelength is variable by varying the wavelength of the surface acoustic wave generated by the transducer.

Consequently, it is an object of the present invention to provide an improved laser module that is both flexible regarding a laser wavelength and that allows for a simple implementation in contrast to the known wavelength tunable systems.

Regarding the abovementioned laser module, this object is achieved by said wavelength setting means bering configured to irreversibly modify the wavelength selecting layer and in that said wavelength setting means are at least partly integrated into said laser module.

The inventive laser module advantageously enables an in-situ setting of the desired wavelength as given by known tunable systems, while at the same time requiring less hardware and operation efforts, because once the inventive wavelength selecting layer has been modified to its desired wavelength selective state, no further tuning or control is required.

It is particularly advantageous to irreversibly modify the wavelength selecting layer according to the present invention in order to attain a wavelength selective state, because no further operation of the wavelength setting means is required once the desired wavelength has been established within the inventive laser module.

By at least partly integrating the inventive wavelength setting means into the laser module, a very flexible operation of the inventive laser module is possible. This way, a not yet wavelength selective laser module may be produced and kept on stock by the suppliers, who advantageously do not have do distinguish between different laser wavelengths of the inventive modules.

Once a customer has obtained such a laser module and has defined a certain field of application for the inventive laser module, the inventive wavelength setting means may be appropriately triggered to establish a corresponding wavelength selective state of the wavelength selecting layer thereby finalizing the configuration of the inventive laser module just in time.

According to an advantageous embodiment of the present invention, the wavelength setting means comprise mechanical imprint means and actuation means to apply said mechanical imprint means to the wavelength selecting layer in order to define a wavelength selecting pattern therein. The mechanical imprint means e.g. have a predetermined geometry which will correspondingly alter the geometry and/or optical properties of the wavelength selecting layer. Different mechanical imprint means may be provided so as to enable a dynamic selection of the wavelength. The mechanical imprint process may be supported by heating the wavelength selecting layer, preferably prior to or during the imprint process.

It is also possible to provide altering means which can e.g. effect a predetermined deformation of the imprint means so as to offer a further degree of freedom when forming the wavelength selective structure. The altering means may e.g. apply a temperature change to the imprint means or they may stretch them by means of electromagnetic and/or piezoelectric actuators.

As an example of mechanical imprint means, silicon molds may be comprised within the laser module, and when setting the wavelength, the silicon mold may be pressed to the wavelength selecting layer of the semiconductor laser to make it wavelength selective. The silicon mold may comprise one or more pre-formed patterns according to the variety of wavelengths that may be set for the laser module, and depending on the desired laser wavelength to be effected, the respective pattern is impressed upon the wavelength selecting layer.

The silicon mold's geometry may be altered thermally or physically, i.e. by stretching, as already explained above.

It is also possible to use other materials for providing suitable molds for the mechanical imprint means.

A further advantageous embodiment of the present invention proposes to deposit a conductive structure on the wavelength selecting layer to transform it to a wavelength selective state. Such deposition may e.g. be effected by applying conductive material such as metal compounds to a mold having a predetermined pattern. The step of applying the metal compound is preferably performed during manufacturing. When pressing the mold to the wavelength selecting layer (preferably in-situ, i.e. after installing the laser module at a specific place in the field), the metal compounds will stick to the wavelength selecting layer because of increased adhesion thereto as compared to the mold itself. Thereby, a conductive pattern the geometry of which is influenced by the mold's geometry may efficiently be applied to the wavelength selecting layer.

As already pointed out, the deposition process itself may be performed in the field, in analogy to the mechanical imprint process, and thereby offers the possibility to fix the laser wavelength at a very late stage, i.e. directly prior to using the laser module.

Said wavelength setting means may also comprise a radiation source capable of forming a predetermined intensity pattern of radiation on said wavelength selecting layer for creating wavelength selective inhomogenities such as a grating pattern or the like within said wavelength selecting layer thereby transforming it to a wavelength selective state. A separate laser source in combination with a phase mask may also be used to effect the change of the wavelength selecting layer to a wavelength selective state.

According to a further advantageous embodiment of the present invention, said wavelength setting means are configured to shift the wavelength selecting layer into a modifiable state, e.g. by applying a temperature change and/or radiation, in which a refractive index and/or further optical properties of said wavelength selecting layer can be altered by radiation that is axially fed to the active region. Such radiation may e.g. provided by a separate laser system that is external to the inventive laser module. The radiation may form a standing wave pattern within the semiconductor laser an electromagnetic field of which interacts with the wavelength selecting layer being in its modifiable state. After a sufficient interaction time, the wavelength selecting layer may be shifted back to a non-modifiable state, e.g. by cooling, and the so modified wavelength selecting layer keeps a wavelength selective optical structure that has been defined by the standing wave pattern. Preferably, the laser light forming the standing wave pattern has the same frequency as desired for the inventive laser module.

According to a further advantageous embodiment of the present invention, said wavelength setting means comprise a plurality of conductive elements on said wavelength selecting layer, and said wavelength setting means are configured to selectively remove, particularly by fusing, predetermined conductive elements in order to establish a wavelength selective state. For example, depending on the desired laser wavelength, a corresponding number of the conductive elements may be eliminated by fusing them. For this purpose, a corresponding current source has to be provided internal or external to the inventive laser module. The non-fused, remaining conductive elements and their geometry define the laser wavelength.

The principle of the present invention is based on the fact that an evanescent electromagnetic field, i.e. the portion of the laser radiation field which is outside of the active region of the semiconductor laser, couples with said wavelength selecting layer. Depending on the structure of the wavelength selecting layer, certain laser wavelengths of the evanescent electromagnetic field are selected thus determining the laser wavelength of the laser module. An initially unstructured, homogenous wavelength selecting layer will basically have no wavelength selective effect. After the inventive modification of the wavelength selecting layer, it comprises a certain, preferably periodic structure comparable to a regular grating or the like.

Accordingly, the inventive idea covers any system and technique that enables to induce a modification of the wavelength selecting layer in-situ. Apart from the explicitly mentioned variants of mechanical imprinting, depositing and radiation pattern forming, further technologies that enable to modify the wavelength selecting layer to attain a wavelength selective structure and that can be performed in the field may be considered as comprised by the present invention.

For instance, the wavelength selecting layer which may comprise polymer material as a basis, may furthermore comprise highly doped regions, wherein a concentration of dopant material may be about 10^20 / cm^3. These highly doped regions exhibit electrical characteristics different from the mere base material (undoped polymer or the like), particularly an increased conductivity. To influence the wavelength selective properties of such a highly doped polymer material, the highly doped regions may be altered by applying electric currents thereto resulting in a material change similar to the fusing approach.

Furthermore, it is not necessary for the inventive wavelength selecting layer to directly be in contact with the active region. The inventive wavelength selective effect can also be achieved with a configuration that provides no direct contact between these components as long as it enables the evanescent field to couple with the wavelength selective structure of the wavelength selecting layer.

The inventive laser module may advantageously be used within optical transmitters of optical communication systems. The possibility to configure the laser wavelength on-the-fly, i.e. even in a fully installed system, reduces the efforts for maintaining a laser module inventory and furthermore increases flexibility, e.g. in cases where system changes have to be realized.

A further solution to the object of the present invention is given by the method according to claim 11.

Further features, aspects and advantages of the present invention are presented in the following detailed description with reference to the drawings, in which:
- Figure 1: depicts a semiconductor laser of a first embodiment of the inventive laser module,
- Figure 2: depicts a top view of the semiconductor laser of Figure 1,
- Figure 3: schematically depicts a first embodiment of the inventive laser module, and
- Figure 4a to 4c: depict further embodiments of the inventive semiconductor laser.

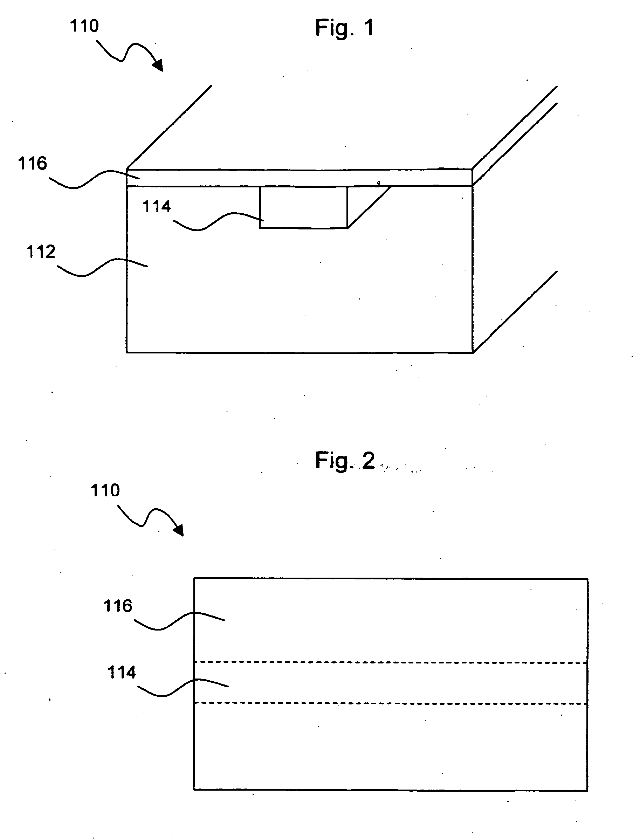

Figure 1 depicts a semiconductor laser 110 that comprises a bulk region 112 and an active region 114 arranged therein. The active region 114 defines a wave guide which may serve to define a laser resonator.

According to the present invention, said semiconductor laser 110 comprises a wavelength selecting layer 116 which is at least partly disposed on the active region 114 and which therefore can interact with an evanescent electromagnetic field that exists outside the active region 114 during an operation of the semiconductor laser 110.

Initially, i.e. after manufacturing of the semiconductor laser 110, the inventive wavelength selecting layer 116 is not yet wavelength selective. In particular, the wavelength selecting layer 116 is e.g. completely homogenous and thus has no wavelength selecting effect on the electromagnetic field within the active region 114.

Figure 2 shows a top view of the semiconductor laser 110 with the active region 114 being indicated by the dashed lines.

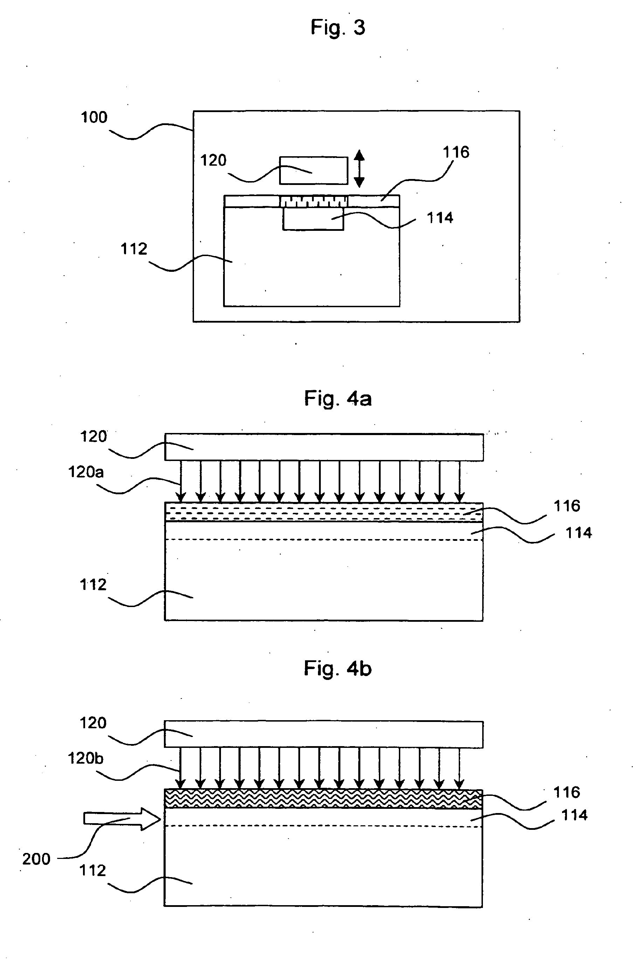

According to the present invention, a laser module 100 as depicted by Figure 3 comprises one or more semiconductor lasers 110 as explained above with reference to Figure 1.

Additionally, the inventive laser module 100 comprises wavelength setting means 120 that are configured to modify the wavelength selecting layer 116 from its initially non-wavelength selective state to a wavelength selective state.

The wavelength setting means 120 may e.g. comprise mechanical imprint means and actuation means to apply said mechanical imprint means to the wavelength selecting layer 116 in order to define a wavelength selecting pattern therein. This process is symbolized by the double arrow of Figure 3 which indicates that said mechanical imprint means comprised within the wavelength setting means 120 are moved to the surface of the wavelength selecting layer 116 for imprinting a specific pattern.

After that, said imprint means may be removed from the surface of the wavelength selecting layer 116 which maintains the imprinted pattern that defines a certain wavelength selectivity. This effect is symbolized within Figure 3 by the dashed region of the wavelength selecting layer 116. The imprinted pattern specifically affects the interaction of the evanescent electromagnetic field that exists within the active region 114 and the material of the wavelength selecting layer 116 thus leading to a corresponding wavelength selection that defines the wavelength of the laser radiation generated within said active region 114.

The wavelength setting means 120 may comprise different sets of imprint means that have different geometries and the like and that may selectively be applied to the wavelength selecting layer 116 to establish a particular laser frequency. It is also possible to influence the geometry of the imprint means by heating or cooling or mechanically stretching the imprint means prior to applying them to the wavelength selecting layer 116, whereby slightly different imprint patterns may be generated which lead to different laser wavelengths.

The imprinting effect is preferably irreversible so that during a further operation of the inventive laser module 100 the laser wavelength may remain constant. Consequently, operation of the inventive laser module 100 is comparatively simple as compared with permanently tunable prior art systems that require a corresponding tuning and control effort during their life time.

As depicted by Figure 3, the wavelength setting means 120 are advantageously integrated within said laser module 100. Although the wavelength setting means 120 are most probably only used once to define the laser wavelength in-situ (for systems with irreversible modification of the wavelength selecting layer 116), the inventive approach efficiently overcomes the problems with the prior art systems that either require a wavelength selection a priori or the disadvantageous permanently tunable lasers.

Electromechanical or piezoelectric actuators (not shown) may e.g. be used as actuation means to drive the mechanical imprint means and/or to stretch the mechanical imprint means.

As an example of mechanical imprint means, one or more pre-patterned silicon molds (not shown) may be comprised within the laser module 100, and when setting the wavelength, a specific pre-patterned silicon mold may be selected and pressed to the wavelength selecting layer 116 of the semiconductor laser 110 to make it wavelength selective. The silicon molds may comprise different pre-formed patterns according to the variety of wavelengths that may be set for the laser module 100.

Silicon molds may also be used to deposit conductive compounds according to a desired pattern to the wavelength selecting layer.

Figure 4a depicts a further variant of the present invention, wherein said wavelength setting means 120 comprise a radiation source capable of forming a predetermined intensity pattern of radiation 120a on said wavelength selecting layer 116 for creating wavelength selective inhomogenities within said wavelength selecting layer 116 thereby transforming it to a wavelength selective state.

The parameters of the inhomogenities and consequently the laser wavelength can e.g. be defined by a phase mask (not shown) which is arranged between the radiation source and the wavelength selecting layer 116 in a per se known manner. As already explained above with reference to the mechanical imprint means, different phase masks with different mask patterns may be provided within said laser module, and one of these masks may be used for transforming the wavelength selecting layer 116 into its wavelength selective state. It is also possible to provide one single phase mask a geometry of which is altered prior to applying radiation to the wavelength selecting layer 116 through said mask.

Figure 4b depicts a further variant of the present invention, wherein said wavelength setting means 120 are configured to shift the wavelength selecting layer 116 into a modifiable state (e.g. by heating) in which a refractive index and/or further optical properties of said wavelength selecting layer 116 can be altered by radiation 200 that is axially fed to the active region 114.

Such radiation 200 may e.g. be provided by a separate laser system (not shown) that is external to the inventive laser module 100. The radiation 200 may form a standing wave pattern within the active region 114 of the semiconductor laser 110, an evanescent electromagnetic field of which interacts with the wavelength selecting layer 116 being in its modifiable state. After a sufficient interaction time, the wavelength selecting layer 116 may be shifted back to a non-modifiable state, e.g. by cooling, and the so modified wavelength selecting layer 116 keeps a wavelength selective optical structure that has been defined by the standing wave pattern of the radiation 200. Preferably, the laser light forming the standing wave pattern has the same frequency as desired for the inventive laser module 100.

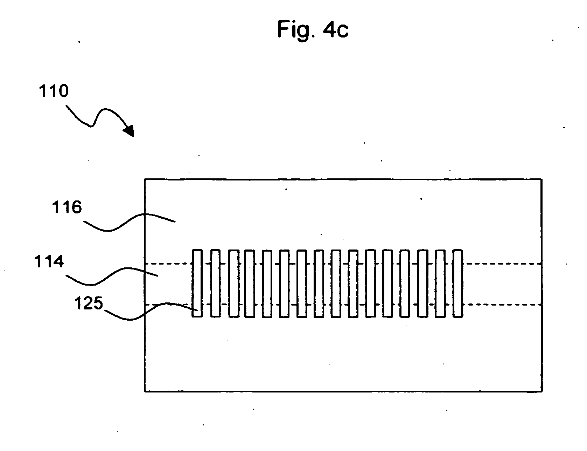

Figure 4c depicts a further variant of the present invention, wherein a plurality of conductive elements 125 are arranged on said wavelength selecting layer 116. With this embodiment, said wavelength setting means 120 (Figure 3) are configured to selectively fuse predetermined conductive elements 125 in order to establish a wavelength selective state. For this purpose, a corresponding current source and a switch matrix enabling the fusing of specific conductive elements 125 is to be provided, preferably completely integrated within said laser module 100.

As already explained above, in-situ depositing of a desired conductive pattern on the wavelength selecting layer 116 is also possible, e.g. by using and providing appropriate molds within the laser module 100 which have been supplied with the conductive compounds to be deposited before. The geometry of such molds may also be altered prior to depositing in order to alter the geometry of the deposition material thereby again altering the wavelength selection properties of the arrangement.

The inventive laser module 100 may advantageously be used within optical transmitters of optical communication systems. The inventive method which provides for an in-situ wavelength setting of the laser module 100 advantageously enables to deploy optical communication systems with a high degree of flexibility. For instance, the network infrastructure may first be installed, wherein, inter alia, the inventive laser modules 100 are used. After that, the wavelength of the already installed inventive laser modules 100 may be set according to the method of the present invention.

The inventive laser module 100 may comprise energy and/or communication interfaces for interfacing to an external control apparatus that initiates and controls the wavelength selection process. For this purpose, e.g. a portable PC may be employed which is temporarily connected to the inventive laser module 100 by means of said communication interfaces. After the procedure, the portable PC may be removed, since the inventive laser module 100 retains a once defined wavelength without further efforts and control.

A device comprising one or more inventive laser modules 100, such as a line card or an ONT (optical network termination) device, may also comprise a local control unit that can be used to control the inventive process of defining the wavelength of the laser module 100.

The inventive laser module 100 may for instance be comprised within an optical transceiver unit, a receiver of which is operational and which may receive information regarding a wavelength desired to be selected for a not yet wavelength configured transmitter having the inventive laser module 100. Upon receiving said information, the inventive wavelength selecting process may be triggered, whereby the transmitter is defined to have the desired wavelength. This way, the optical transceiver may efficiently and remotely be configured to assume a desired transmission wavelength.

The wavelength selecting layer 116 may e.g. comprise a doped polymer film which can be modified in the above described manner.

Generally, according to the present invention, it is also possible to provide only a part of the active region 114 / the adjacent wavelength selecting layer 116 with the inventive wavelength selective structure. I.e., if a laser cavity comprising the active region 114 additionally comprises an undoped, i.e. non-laseractive region, the wavelength selecting layer 116 may comprise the inventive wavelength selective structure only adjacent to the active (i.e., doped) region or to the undoped region or both regions.

## Claims

1. Laser module (100) comprising a semiconductor laser (110) having a bulk region (112) and an active region (114) arranged in said bulk region (112), wherein said laser module (100) comprises a wavelength selecting layer (116) which is at least partly disposed on the active region (114) for selecting a laser.wavelength of the semiconductor laser (110) and which initially has a non-wavelength selective, particularly homogenous, state, and wavelength setting means (120) that are configured to modify the wavelength selecting layer (116) from its initially non-wavelength selective state to a wavelength selective state, **characterized in that** said wavelength setting means (120) are configured to irreversibly modify the wavelength selecting layer (116) and **in that** said wavelength setting means (120) are at least partly integrated into said laser module (100).

2. Laser module (100) according to claim 1, **characterized in that** said wavelength setting means (120) comprise mechanical imprint means and actuation means to.apply said mechanical imprint means to the wavelength selecting layer (116) in order to define a wavelength selecting pattern therein.

3. Laser module (100) according to claim 2, **characterized by** altering means for altering an imprint pattern of said mechanical imprint means.

4. Laser module (100) according to one of the preceding claims, **characterized in that** said wavelength setting means (120) comprise a radiation source capable of forming a predetermined intensity pattern of radiation (120a) on said wavelength selecting layer (116) for creating wavelength selective inhomogenities within said wavelength selecting layer (116) thereby transforming it to a wavelength selective state.

5. Laser module (100) according to one of the preceding claims, **characterized in that** said wavelength setting means (120) are configured to shift the wavelength selecting layer (116) into a modifiable state in which a refractive index and/or.further optical properties of said wavelength selecting layer (116) can be altered by radiation (200) that is axially fed to the active region (114).

6. Laser module (100) according to one of the preceding claims, **characterized in that** said wavelength setting means (120) are configured to apply heat to the wavelength selecting layer (116).

7. Laser module (100) according to one of the preceding claims, **characterized in that** said wavelength setting means (120) comprise a plurality of conductive elements (125) on said wavelength selecting layer (116), and **in that** said wavelength setting means (120) are configured to selectively remove, in particular by fusing, predetermined conductive elements (125) in order to establish a wavelength selective state.

8. Optical transmitter comprising at least one laser module (100) according to one of the preceding claims.

9. Method of providing a laser module (100) having a predetermined wavelength, wherein a semiconductor laser (110) is provided having a bulk region (112) and an active region (114) arranged in said bulk region (112), wherein a wavelength selecting layer (116) is provided on the active region (114) for selecting a laser wavelength of the semiconductor laser (110), wherein said wavelength selecting layer (116) initially has a non-wavelength selective, particularly homogenous, state, **characterized by** irreversibly modifying the wavelength selecting layer (116) from its initially non-wavelength selective state to a wavelength selective state by means of wavelength setting means (120) that are at least partially comprised within said laser module (100).

10. Method according to claim 9, **characterized in that** said step of modifying the wavelength selecting layer (116) comprises defining a wavelength selecting pattern therein by means of mechanical imprint means.

11. Method according to one of the claims 9 to 10, **characterized in that** said step of modifying the wavelength selecting layer (116) comprises forming a predetermined intensity pattern of radiation (120a) on said wavelength selecting layer (116) for creating wavelength selective inhomogenities within said wavelength selecting layer (116) thereby transforming it to a wavelength selective state.

## Patentansprüche

1. Lasermodul (100), umfassend einen Halbleiterlaser (110) mit einem Substratbereich (112) und einem aktiven Bereich (114), welcher in dem besagten Substratbereich (112) eingerichtet ist, wobei das besagte Lasermodul (100) eine wellenlängenselektive Schicht (116) umfasst, welche zumindest teilweise auf dem aktiven Bereich (114) zum Auswählen einer Laserwellenlänge des Halbleiterlasers (110) angeordnet ist, und welche ursprünglich einen nicht wellenlängenselektiven, besonders homogenen Zustand aufweist, sowie Wellenlängeneinstellmittel (120), welche konfiguriert sind, um die wellenlängenselektive Schicht (116) von ihrem ursprünglich nicht wellenlängenselektiven Zustand in einen wellenlängenselektiven Zustand zu versetzen, **dadurch gekennzeichnet, dass** die besagten Wellenlängeneinstellmittel (120) konfiguriert sind, um die wellenlängenselektive Schicht (116) irreversibel zu verändern, und dass die besagten Wellenlängeneinstellmittel (120) zumindest teilweise in dem besagten Lasermodul (100) integriert sind.

2. Lasermodul (100) nach Anspruch 1, **dadurch gekennzeichnet, dass** die besagten Wellenlängeneinstellmittel (120) mechanische Druckmittel sowie Betätigungsmittel zum Anwenden der besagten mechanischen Druckmittel auf der besagten wellenlängenselektiven Schicht (116) umfassen, um ein wellenlängenselektives Muster darin zu definieren.

3. Lasermodul (100) nach Anspruch 2, **gekennzeichnet durch** Veränderungsmittel zum Verändern eines Druckmusters der besagten mechanischen Druckmittel.

4. Lasermodul (100) nach einem der vorangehenden Ansprüche, **dadurch gekennzeichnet, dass** die besagten Wellenlängeneinstellmittel (120) eine Strahlungsquelle umfassen, welche fähig ist, ein vorbestimmtes Intensitätsmuster der Strahlung (120a) auf der besagten wellenlängenselektiven Schicht (116) zu bilden, um innerhalb der besagten wellenlängenselektiven Schicht (116) wellenlängenselektive Inhomogenitäten zu erzeugen und diese dadurch in einen wellenlängenselektiven Zustand zu versetzen.

5. Lasermodul (100) nach einem der vorangehenden Ansprüche, **dadurch gekennzeichnet, dass** die besagten Wellenlängeneinstellmittel (120) konfiguriert sind, um die wellenlängenselektive Schicht (116) in einen veränderbaren Zustand zu versetzen, in welchem ein Brechungsindex und/oder weitere optische Eigenschaften der besagten wellenlängenselektiven Schicht (116) durch eine Strahlung (200), welche axial in den aktiven Bereich (114) eingespeist wird, verändert werden kann.

6. Lasermodul (100) nach einem der vorangehenden Ansprüche, **dadurch gekennzeichnet, dass** die besagten Wellenlängeneinstellmittel (120) konfiguriert sind, um Wärme auf die wellenlängenselektive Schicht (116) zu übertragen.

7. Lasermodul (100) nach einem der vorangehenden Ansprüche, **dadurch gekennzeichnet, dass** die besagten Wellenlängeneinstellmittel (120) eine Vielzahl von Leiterelementen (125) auf der besagten wellenlängenselektiven Schicht (116) umfassen, und dass die besagten Wellenlängeneinstellmittel (120) konfiguriert sind, um vorbestimmte Leiterelemente (125) selektiv, insbesondere durch Schmelzen, zu entfernen, um einen wellenlängenselektiven Zustand herzustellen.

8. Optischer Sender, welcher mindestens ein Lasermodul (100) nach einem der vorangehenden Ansprüche umfasst.

9. Verfahren zum Bereitstellen eines Lasermoduls (100) mit einer vorbestimmten Wellenlänge, wobei ein Halbleiterlaser (110) mit einem Substratbereich (112) und einem aktiven Bereich (114), welcher in dem besagten Substratbereich (112) eingerichtet ist, bereitgestellt wird, wobei eine wellenlängenselektive Schicht (116) auf dem aktiven Bereich (114) zum Auswählen einer Laserwellenlänge des Halbleiterlasers (110) bereitgestellt wird, wobei sich die besagte wellenlängenselektive Schicht (116) ursprünglich in einem nicht wellenlängenselektiven, besonders homogenen Zustand befindet, **gekennzeichnet durch** das unwiderrufliche Verändern der wellenlängenselektiven Schicht (116) von ihrem ursprünglich nicht wellenlängenselektiven Zustand in einen wellenlängenselektiven Zustand anhand von Wellenlängeneinstellmittel (120), welche zumindest teilweise in dem besagten Lasermodul (100) enthalten sind.

10. Verfahren nach Anspruch 9, **dadurch gekennzeichnet, dass** der besagte Schritt des Veränderns der wellenlängenselektiven Schicht (116) das Definieren eines wellenlängenselektiven Musters darin anhand von mechanischen Druckmitteln umfasst.

11. Verfahren nach einem der Ansprüche 9 bis 10, **dadurch gekennzeichnet, dass** der besagte Schritt des Veränderns der wellenlängenselektiven Schicht (116) das Bilden eines vorbestimmten Intensitätsmusters der Strahlung (120a) auf der besagten wellenlängenselektiven Schicht (116) umfasst, um innerhalb der besagten wellenlängenselektiven Schicht (116) wellenlängenselektive Inhomogenitäten zu erzeugen und diese dadurch in einen wellenlängenselektiven Zustand zu versetzen.

## Revendications

1. Module laser (100) comprenant un laser à semiconducteur (110) doté d'une région de cristal fondamental (112) et d'une région active (114) disposée dans ladite région de cristal fondamental (112), ledit module laser (100) comprenant une couche de sélection de la longueur d'onde (116) qui est au moins partiellement disposée sur la région active (114) pour sélectionner une longueur d'onde de laser du laser à semiconducteur (110) et qui présente initialement un état particulièrement homogène sans sélection de la longueur d'onde, et des moyens de réglage de la longueur d'onde (120) qui sont configurés pour modifier la couche de sélection de la longueur d'onde (116) de son état initial sans sélection de la longueur d'onde en un état de sélection de la longueur d'onde, **caractérisé en ce que** lesdits moyens de réglage de la longueur d'onde (120) sont configurés pour modifier de manière irréversible la couche de sélection de la longueur d'onde (116) et **en ce que** lesdits moyens de réglage de la longueur d'onde (120) sont au moins partiellement intégrés dans ledit module laser (100).

2. Module laser (100) selon la revendication 1, **caractérisé en ce que** lesdits moyens de réglage de la longueur d'onde (120) comprennent des moyens de marquage mécaniques et des moyens d'actionnement pour appliquer lesdits moyens de marquage mécaniques sur la couche de sélection de la longueur d'onde (116) afin d'y définir un motif de sélection de la longueur d'onde.

3. Module laser (100) selon la revendication 2, **caractérisé par** des moyens de modification pour modifier un motif marqué desdits moyens de marquage mécaniques.

4. Module laser (100) selon l'une des revendications précédentes, **caractérisé en ce que** lesdits moyens de réglage de la longueur d'onde (120) comprennent une source de rayonnement capable de former un motif de rayonnement (120a) d'intensité prédéterminée sur ladite couche de sélection de la longueur d'onde (116) pour créer des défauts d'homogénéité de sélection de la longueur d'onde à l'intérieur de ladite couche de sélection de la longueur d'onde (116), la transformant ainsi en un état de sélection de la longueur d'onde.

5. Module laser (100) selon l'une des revendications précédentes, **caractérisé en ce que** lesdits moyens de réglage de la longueur d'onde (120) sont configurés pour décaler la couche de sélection de la longueur d'onde (116) en un état modifiable dans lequel un indice de réfraction et/ou d'autres propriétés optiques de ladite couche de sélection de la longueur d'onde (116) peuvent être modifiés par un rayonnement (200) qui est acheminé dans le sens axial vers la région active (114).

6. Module laser (100) selon l'une des revendications précédentes, **caractérisé en ce que** lesdits moyens de réglage de la longueur d'onde (120) sont configurés pour appliquer de la chaleur à la couche de sélection de la longueur d'onde (116).

7. Module laser (100) selon l'une des revendications précédentes, **caractérisé en ce que** lesdits moyens de réglage de la longueur d'onde (120) comprennent une pluralité d'éléments conducteurs (125) sur ladite couche de sélection de la longueur d'onde (116) et **en ce que** lesdits moyens de réglage de la longueur d'onde (120) sont configurés pour retirer de manière sélective, notamment par fusion, des éléments conducteurs (125) prédéterminés afin d'établir un état de sélection de la longueur d'onde.

8. Émetteur optique comprenant au moins un module laser (100) selon l'une des revendications précédentes.

9. Procédé de fourniture d'un module laser (100) ayant une longueur d'onde prédéterminée, un laser à semiconducteur (110) étant fourni et doté d'une région de cristal fondamental (112) et d'une région active (114) disposée dans ladite région de cristal fondamental (112), une couche de sélection de la longueur d'onde (116) étant fournie sur la région active (114) pour sélectionner une longueur d'onde de laser du laser à semiconducteur (110), ladite couche de sélection de la longueur d'onde (116) présentant initialement un état particulièrement homogène sans sélection de la longueur d'onde, **caractérisé par** une modification irréversible de la couche de sélection de la longueur d'onde (116) de son état initial sans sélection de la longueur d'onde en un état de sélection de la longueur d'onde à l'aide de moyens de réglage de la longueur d'onde (120) qui sont au moins partiellement compris dans ledit module laser (100).

10. Procédé selon la revendication 9, **caractérisé en ce que** l'étape de modification de la couche de sélection de la longueur d'onde (116) comprend la définition dans celle-ci d'un motif de sélection de la longueur d'onde à l'aide de moyens de marquage mécaniques.

11. Procédé selon l'une des revendications 9 à 10, **caractérisé en ce que** ladite étape de modification de la couche de sélection de la longueur d'onde (116) comprend la formation d'un motif de rayonnement (120a) d'intensité prédéterminée sur ladite couche de sélection de la longueur d'onde (116) pour créer des défauts d'homogénéité de sélection de la longueur d'onde à l'intérieur de ladite couche de sélection de la longueur d'onde (116), la transformant ainsi en un état de sélection de la longueur d'onde.
